(19) Europäisches Patentamt
European Patent Office
Office européen des brevets

(11) **EP 4 227 847 A1**

(12) **EUROPEAN PATENT APPLICATION**
published in accordance with Art. 153(4) EPC

(43) Date of publication:
**16.08.2023 Bulletin 2023/33**

(21) Application number: **20956677.7**

(22) Date of filing: **06.10.2020**

(51) International Patent Classification (IPC):
**G06F 30/27** (2020.01)          **G06F 30/398** (2020.01)

(52) Cooperative Patent Classification (CPC):
**G06F 30/27; G06F 30/398**

(86) International application number:
**PCT/JP2020/037829**

(87) International publication number:
**WO 2022/074728 (14.04.2022 Gazette 2022/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **FUJITSU LIMITED**
**Kawasaki-shi, Kanagawa 211-8588 (JP)**

(72) Inventors:
• **YAMADA, Hiroaki**
**Kawasaki-shi, Kanagawa 211-8588 (JP)**

• **YAMANE, Shohei**
**Kawasaki-shi, Kanagawa 211-8588 (JP)**
• **YAMAZAKI, Takashi**
**Kawasaki-shi, Kanagawa 211-8588 (JP)**
• **KOCHIBE, Yoichi**
**Kawasaki-shi, Kanagawa 211-8588 (JP)**
• **OHARA, Toshiyasu**
**Kawasaki-shi, Kanagawa 211-8588 (JP)**

(74) Representative: **Hoffmann Eitle**
**Patent- und Rechtsanwälte PartmbB**
**Arabellastraße 30**
**81925 München (DE)**

(54) **TRAINING DATA GENERATION PROGRAM, TRAINING DATA GENERATION METHOD, AND TRAINING DATA GENERATION DEVICE**

(57)    A training data generation program causes a computer to execute processing including: calculating a characteristic impedance of a circuit included in each of a first plurality of pieces of circuit information; classifying the plurality of pieces of circuit information based on the calculated characteristic impedance; selecting one or a plurality of pieces of circuit information from a second plurality of pieces of circuit information classified into a first group by the processing of classifying; and generating training data for machine learning based on the selected one or a plurality of pieces of circuit information.

FIG. 1

EP 4 227 847 A1

**Description**

FIELD

The present disclosure relates to a training data generation technology.

BACKGROUND

Machine learning technologies are used to predict electromagnetic interference (EMI) in electronic circuits. Here, the EMI refers to a situation of electromagnetic wave radiation radiated from the electronic circuit. Furthermore, the EMI is also called a far field because of an aspect of the situation of the electromagnetic wave radiation that refers to a situation of a far electromagnetic field.

For example, an EMI intensity in a circuit to be predicted is predicted by using a trained machine learning model generated from training data in which circuit information is associated with a simulation result of electromagnetic wave analysis for the circuit information.

SUMMARY

TECHNICAL PROBLEM

However, in a case where the EMI intensity is predicted by the machine learning model described above, since training data of circuits with various substrate characteristics is needed for training the machine learning model described above, the number of pieces of training data used for machine learning increases.

In one aspect, an object of the present disclosure is to provide a training data generation program, a training data generation method, and a training data generation device that may implement reduction in the number of pieces of training data for machine learning.

SOLUTION TO PROBLEM

In one proposal, a training data generation program causes a computer to execute processing including: calculating a characteristic impedance of a circuit included in each of a first plurality of pieces of circuit information; classifying the plurality of pieces of circuit information based on the calculated characteristic impedance; selecting one or a plurality of pieces of circuit information from a second plurality of pieces of circuit information classified into a first group by the processing of classifying; and generating training data for machine learning based on the selected one or a plurality of pieces of circuit information.

ADVANTAGEOUS EFFECTS OF INVENTION

It is possible to implement reduction in the number of pieces of training data for machine learning.

BRIEF DESCRIPTION OF DRAWINGS

FIG. 1 is a block diagram illustrating an example of a functional configuration of a server device according to a first embodiment.
FIG. 2 is a diagram illustrating an example of a simple circuit and a complex circuit.
FIG. 3 is a diagram illustrating an example of a machine learning method of an EMI prediction model.
FIG. 4 is a diagram illustrating an example of EMI prediction of the complex circuit.
FIG. 5 is a diagram illustrating an example of EMI prediction of a circuit with elements.
FIG. 6 is diagram illustrating an example of variations in substrate characteristics.
FIG. 7 is diagram illustrating another example of the variations in the substrate characteristics.
FIG. 8 is a diagram illustrating one aspect of a relationship between a characteristic impedance and EMI.
FIG. 9 is a diagram illustrating an example of filtering.
FIG. 10 is a diagram illustrating an example of an enumeration method of circuits.
FIG. 11 is a diagram illustrating an example of a method of setting a division line for a line.
FIG. 12 is a flowchart illustrating a procedure of training data generation processing according to the first embodiment.
FIG. 13 is a diagram illustrating an application example of the filtering.

FIG. 14 is a diagram illustrating a hardware configuration example of a computer.

DESCRIPTION OF EMBODIMENTS

Hereinafter, a training data generation program, a training data generation method, and a training data generation device according to the present application will be described with reference to the accompanying drawings. Note that the embodiments do not limit the disclosed technology. Additionally, each of the embodiments may be appropriately combined within a range without causing contradiction between processing contents.

[First Embodiment]

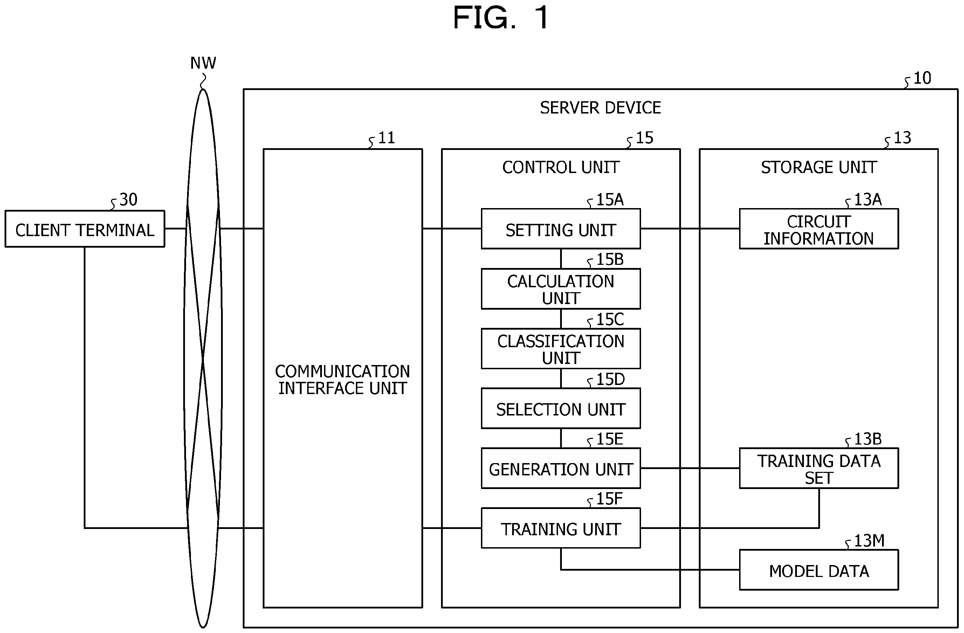

FIG. 1 is a block diagram illustrating an example of a functional configuration of a server device 10 according to a first embodiment. The server device 10 illustrated in FIG. 1 is an example of a computer that provides a training data generation function of generating training data used for training a machine learning model that predicts an EMI intensity in an electronic circuit. Hereinafter, the machine learning model that predicts the EMI intensity in the electronic circuit may be referred to as an "EMI prediction model".

Such a training data generation function may be packaged as one function of a machine learning service that executes machine learning of the EMI prediction model by using the training data described above. In addition, the training data generation function described above or the machine learning service described above may be packaged as one function of a model provision service that provides a trained EMI prediction model, or as one function of an EMI prediction service that predicts an EMI intensity of a circuit by using a trained EMI prediction model. Moreover, the model provision service described above or the EMI prediction service described above may be packaged as one function of a simulation service that executes simulation of electromagnetic wave analysis.

For example, the server device 10 may be implemented by installing a training data generation program that implements the training data generation function described above to an optional computer. As an example, the server device 10 may be implemented as a server that provides the training data generation function described above on-premises. As another example, the server device 10 may also be implemented as a software as a service (SaaS) type application to provide the training data generation function described above as a cloud service.

Furthermore, as illustrated in FIG. 1, the server device 10 may be communicably coupled to a client terminal 30 via a network NW. For example, the network NW may be an optional type of communication network such as the Internet or a local area network (LAN) regardless of whether the network NW is wired or wireless.

The client terminal 30 is an example of a computer that receives provision of the training data generation function described above. For example, a desktop-type computer such as a personal computer, or the like may correspond to the client terminal 30. This is merely an example, and the client terminal 30 may be an optional computer such as a laptop-type computer, a mobile terminal device, or a wearable terminal.

Note that, although FIG. 1 gives an example in which the training data generation function described above is provided by a client-server system, the present invention is not limited to this example, and the training data generation function described above may be provided in a standalone manner.

As one aspect, the EMI prediction described above has one aspect that it is useful for design of electronic circuit boards, so-called circuit design. In other words, in the circuit design, from a standpoint of standards and regulations, there is a great interest in keeping radiated electromagnetic waves observed in a circuit within a prescribed value determined for each frequency. Accordingly, in the circuit design, EMI prediction is performed by simulation of electromagnetic wave analysis. However, factors such as a cost of modeling a circuit and a calculation cost of a simulator are hurdles to perform the simulation.

From such background, a machine learning technology such as a neural network, for example, a convolutional neural network (CNN) or the like, is used. For example, as described above in the background art section described above, an EMI intensity in a circuit to be analyzed is predicted by using a trained EMI prediction model generated from training data in which circuit information is associated with a simulation result of electromagnetic wave analysis for the circuit information.

In a case there the EMI intensity of the circuit is predicted by using the EMI prediction model in this way, a condition for accuracy of the EMI prediction to reach a certain level is that training data from which circuit features affecting EMI are extracted is used to train the EMI prediction model.

However, there are various circuit features affecting EMI. Examples of the circuit features include a shape of a line arranged on the circuit, or arrangement of elements on the line of the circuit, such as a resistor, a coil, and a capacitor, for example. Therefore, the training for the EMI prediction described above needs a huge amount of training data.

Accordingly, there are Advanced Technology 1 and Advanced Technology 2 as technologies that implement reduction in the number of pieces of training data. Advanced technology 1 and Advanced Technology 2 given here are distinguished from conventional technologies referred to in publicly known patent documents, non-patent documents, and the like.

In Advanced Technology 1, circuits are classified into "simple circuits" and "complex circuits" depending on presence or absence of a branch in a line wired to the circuit. For example, among the circuits, a circuit without a branch is classified as the "simple circuit", while a circuit with a branch is classified as the "complex circuit". Under such classification, in Advanced Technology 1, a point of view that a complex circuit may be expressed by a combination of simple circuits is used to solve the problem of reducing the number of pieces of training data.

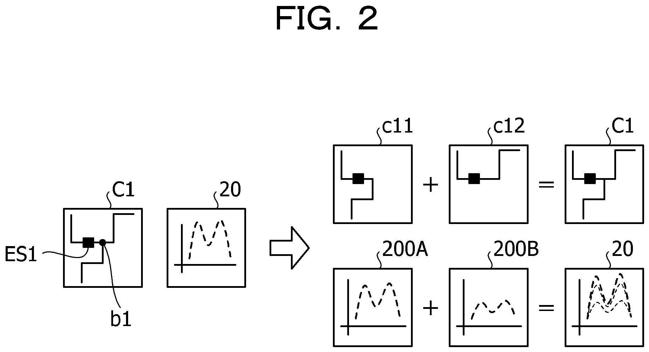

FIG. 2 is a diagram illustrating an example of the simple circuit and the complex circuit. FIG. 2 illustrates a complex circuit C1 as an example, and a simple circuit c11 and a simple circuit c12 as an example of a combination of simple circuits corresponding to the complex circuit C1. As illustrated in FIG. 2, the complex circuit C1 may be divided into the simple circuit c11 and the simple circuit c12 by using a branch point b1 as a boundary. In this case, the complex circuit C1 is divided so that combinations of a partial line including an excitation source ES1 and each of partial lines not including the excitation source ES1 among the three partial lines branching from the branch point b1 are the lines of the simple circuit c11 and the simple circuit c12. Not only the complex circuit C1 is obtained by combining the simple circuit c11 and the simple circuit c12, but also an EMI intensity 20 of the complex circuit C1 is obtained by combining an EMI intensity 200A of the simple circuit c11 and an EMI intensity 200B of the simple circuit c12.

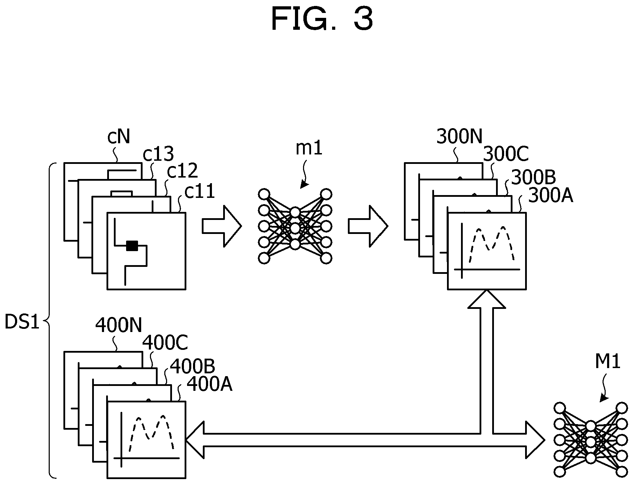

FIG. 3 is a diagram illustrating an example of a machine learning method of an EMI prediction model. As illustrated in FIG. 3, a training data set DS1 is used for machine learning of an EMI prediction model M1. For example, the training data set DS1 is a set of training data in which circuit information of the simple circuits c11 to cN are associated with EMI intensities 400A to 400N observed in each of the simple circuits c11 to cN. The "circuit information" referred to here may include information regarding a network of elements included in an electronic circuit, such as a netlist, for example. Furthermore, the "EMI intensity" referred to here may be, as merely an example, a distribution of EMI intensities in a specific frequency domain, a so-called EMI spectrum.

For example, in a case where the circuit information of the simple circuit c11 is input to an EMI prediction model m1, an EMI intensity 300A is output from the EMI prediction model m1. Similarly, by inputting the circuit information of the simple circuits c12 to cN to the EMI prediction model m1, output of EMI intensities 300B to 300N is obtained from the EMI prediction model m1. Then, parameters of the EMI prediction model m1 are updated based on a loss between the EMI intensities 300A to 300N as the output from the EMI prediction model m1 and the EMI intensities 400A to 400N as correct answer labels. In this way, machine learning of the EMI prediction model m1 is executed by using the circuit information of the simple circuits c11 to cN as feature amounts, so-called explanatory variables, and the EMI intensities as objective variables. With this configuration, the trained EMI prediction model M1 that implements EMI prediction of the simple circuit is obtained.

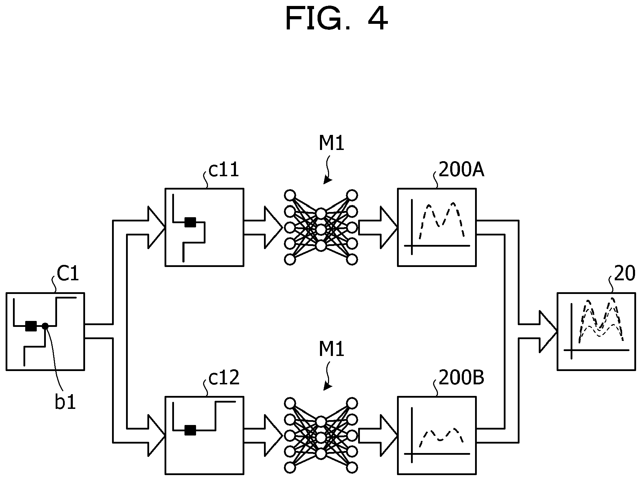

FIG. 4 is a diagram illustrating an example of EMI prediction of the complex circuit. FIG. 4 illustrates, as an example, a case of predicting the EMI intensity of the complex circuit C1 by using the trained EMI prediction model M1 illustrated in FIG. 3. As illustrated in FIG. 4, in a case where the complex circuit C1 is to be predicted, the complex circuit C1 is divided into the simple circuit c11 and the simple circuit c12 by using the branch point b1 as the boundary. Thereafter, EMI prediction of the simple circuit c11 and EMI prediction of the simple circuit c12 are performed in parallel. In other words, by inputting the circuit information of the simple circuit c11 to the EMI prediction model M1, an EMI intensity estimated value 200A is obtained as output from the EMI prediction model M1. Furthermore, by inputting the circuit information of the simple circuit c12 to the EMI prediction model M1, an EMI intensity estimated value 200B is obtained as output from the EMI prediction model M1. By combining the EMI intensity estimated value 200A and the EMI intensity estimated value 200B, an EMI intensity estimated value 20 of the complex circuit C1 is obtained.

In this way, in Advanced Technology 1, it is possible to implement the EMI prediction of the complex circuit by combining results of the EMI prediction of the simple circuits by the EMI prediction model M1 for simple circuits. Thus, according to Advanced Technology 1, it is possible to reduce the pieces of training data of the complex circuit. Moreover, in Advanced Technology 1, a domain of an EMI prediction model with more branching patterns of a line of a circuit is more effective in reducing the number of pieces of training data.

Next, in Advanced Technology 2, one of points of view is a point that a circuit with elements including LCR elements such as an inductor (L), a capacitor (C), and a resistor (R) may be expressed by a combination of two patterns: a pattern in which a current is reflected by the elements and a pattern in which a current is not reflected by the elements. Hereinafter, among current components flowing in the circuit with elements, a current component reflected by the elements may be referred to as a "reflection component", and a current component not reflected by the elements may be referred to as a "non-reflection component".

For example, in Advanced Technology 2, a circuit with elements is divided into a reflection equivalent circuit and a non-reflection equivalent circuit. The "reflection equivalent circuit" referred to here refers to a circuit in which lines of a portion of wiring of the circuit with elements where a current is observed are used as wiring under a condition that a ratio of the reflection component and the non-reflection component is 1 : 0, in other words, a condition that the non-reflection component is not observed and only the reflection component is observed. On the other hand, the "non-reflection equivalent circuit" refers to a circuit in which lines of a portion of wiring of the circuit with elements where a current is observed are used as wiring under a condition that the ratio of the reflection component and the non-reflection component is 0 : 1, in other words, a condition that the reflection component is not observed and only the non-reflection component is observed.

Then, in Advanced Technology 2, machine learning of an EMI prediction model m2 is executed by performing narrowing down to two circuits, the reflection equivalent circuit and the non-reflection equivalent circuit, per one circuit with elements. At this time, an explanatory variable of the EMI prediction model m2 may be a current distribution calculated from circuit information of the reflection equivalent circuit or circuit information of the non-reflection equivalent circuit. The "circuit information" referred to here may include information regarding a network of elements included in an electronic circuit, such as a netlist, for example, as well as a physical property values of each element, such as a resistance value, inductance, and capacitance, for example. For example, all current distributions calculated for each frequency component included in a frequency domain may be used for the machine learning of the EMI prediction model m2, but a current distribution of resonant frequencies may be used as a current distribution representative of the frequency domain, as will be described in detail later. Parameters of the EMI prediction model m2 are updated based on a loss between an EMI intensity as a correct answer label and output of the EMI prediction model m1 obtained by inputting the current distribution of the reflection equivalent circuit or the non-reflection equivalent circuit obtained in this way into the EMI prediction model m2. With this configuration, an EMI prediction model M2 is obtained in which only the reflection equivalent circuit and the non-reflection equivalent circuit have been trained.

Here, in Advanced Technology 2, from an aspect of implementing EMI prediction of the circuit with elements by combining the reflection equivalent circuit and the non-reflection equivalent circuit, the following reference data is generated as reference data to be referenced at the time of the EMI prediction of the circuit with elements.

For example, as the reference data, a lookup table, a function, or the like may be used in which a correspondence relationship between physical property values of an element arranged in the circuit with elements and a ratio of a reflection component and a non-reflection component is defined. As merely an example, reflection occurs in a region where a value of the inductor (L) is extremely large, a region where a value of the capacitor (C) is extremely small, and a region where a value of the resistor (R) is extremely large. On the other hand, reflection is sufficiently small in regions other than these regions.

As merely an example, an example will be described in which reference data is generated from a circuit in which the capacitor (C) is arranged. In this case, physical property values of an element in which the ratio of the reflection component and the non-reflection component is 1 : 0 and physical property values of an element in which the ratio of the reflection component and the non-reflection component is 0 : 1 are searched for. For example, under a condition that capacitance of the capacitor (C) is 1 nF, the reflection component is not observed, and only the non-reflection component is observed. In this case, the capacitance "1 nF" of the capacitor (C) is associated with the reflection component "0" and the non-reflection component "1". Furthermore, under a condition that the capacitance of the capacitor (C) is 1 pF, the reflection component and the non-reflection component are observed in equal proportions. In this case, the capacitance "1 pF" of the capacitor (C) is associated with the reflection component "0.5" and the non-reflection component "0.5". Moreover, under a condition that the capacitance of the capacitor (C) is 100 fF, the non-reflection component is not observed, and only the reflection component is observed. In this case, the capacitance "1 fF" of the capacitor (C) is associated with the reflection component "1" and the non-reflection component "0". These correspondence relationships are generated as the reference data. Note that, here, one ratio of the reflection component and the non-reflection component corresponding to 1 pF in the range of the capacitance of the capacitor (C) from 100 fF to 1 nF has been given as an example, but an optional number of correspondence relationships may be defined.

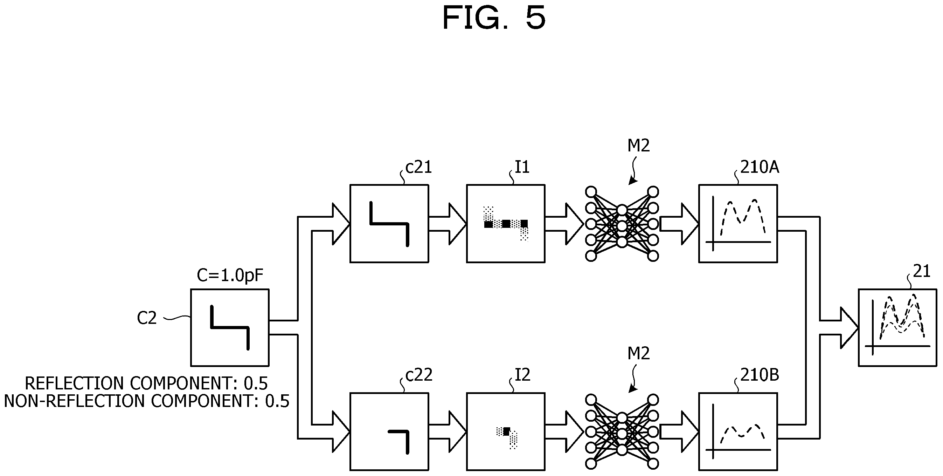

In Advanced Technology 2, under the situation where the trained EMI prediction model M2 and the reference data are obtained, it is possible to implement the EMI prediction of the circuit with elements. FIG. 5 is a diagram illustrating an example of the EMI prediction of the circuit with elements. FIG. 5 illustrates, as an example, a case of predicting an EMI intensity of a circuit C2 with elements by using the trained EMI prediction model M2. As illustrated in FIG. 5, in a case where the circuit C2 with elements is to be predicted, the ratio "0.5 : 0.5" of the reflection component and the non-reflection component corresponding to the capacitance "1.0 pF" of the capacitor (C) included in circuit information of the circuit C2 with elements is referenced from the reference data. Then, the circuit C2 with elements is divided into a reflection equivalent circuit c21 and a non-reflection equivalent circuit c22.

Thereafter, EMI prediction of the reflection equivalent circuit c21 and EMI prediction of the non-reflection equivalent circuit c22 are performed in parallel. In other words, a current distribution I1 of the reflection equivalent circuit c21 is calculated by inputting circuit information of the reflection equivalent circuit c21 to a circuit simulator. By inputting the current distribution I1 of the reflection equivalent circuit c21 calculated in this way to the EMI prediction model M2, an EMI intensity estimated value 210A is obtained as output from the EMI prediction model M2. Furthermore, a current distribution I2 of the non-reflection equivalent circuit c22 is calculated by inputting circuit information of the non-reflection equivalent circuit c22 to the circuit simulator. By inputting the current distribution I2 of the non-reflection equivalent circuit c22 calculated in this way to the EMI prediction model M2, an EMI intensity estimated value 210B is obtained as output from the EMI prediction model M2. By combining the EMI intensity estimated value 210A and the EMI intensity estimated value 210B according to the ratio "0.5 : 0.5" of the reflection component and the non-reflection component referenced from the reference data, an EMI intensity estimated value 21 of the circuit C2 with elements is obtained.

In this way, in Advanced Technology 2, it is possible to implement the EMI prediction of the circuit with elements by combining results of the EMI prediction of the reflection equivalent circuit and the non-reflection equivalent circuit. Thus, according to Advanced Technology 2, it is possible to reduce pieces of training data of circuits other than the two circuits, the reflection equivalent circuit and the non-reflection equivalent circuit, per one circuit with elements. Moreover, in Advanced Technology 2, a domain of an EMI prediction model with more elements arranged in a circuit and more patterns of physical property values thereof is more effective in reducing the number of pieces of training data.

However, even with Advanced Technology 1 and Advanced Technology 2, it is difficult to reduce the number of pieces of training data used for machine learning of an EMI prediction model related to a domain with variations in substrate characteristics.

The "substrate characteristics" referred to here refer to characteristics related to a substrate on which a circuit is printed, such as a width of a line (line width), a thickness of the substrate (layer thickness), and a type of substrate resin (dielectric constant). When at least any one of the substrate characteristics exemplified here changes, EMI also changes even when other substrate characteristics remain the same.

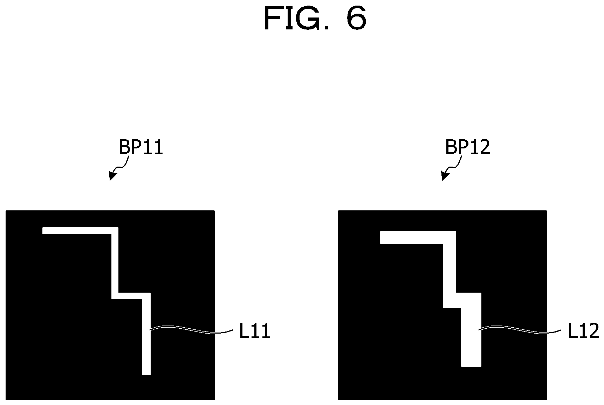

FIG. 6 is diagram illustrating an example of the variations in the substrate characteristics. FIG. 6 exemplifies top views of a substrate BP11 and a substrate BP12 having different widths of lines (line widths) as an example of the variations in the substrate characteristics. As illustrated in FIG. 6, between the substrate BP11 and the substrate BP12, a line L11 and a line L12 having the same shape are printed, while the line widths of the line L11 and the line L12 are different. In a case where there are variations in the line widths in this way, EMI of the substrate BP11 and the substrate BP12 also changes because electrical characteristics also change between the substrate BP11 and the substrate BP12.

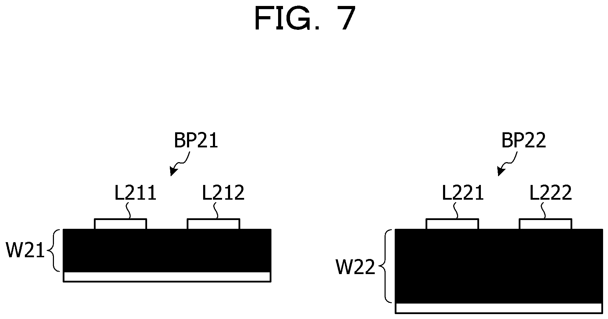

FIG. 7 is diagram illustrating another example of the variations in the substrate characteristics. FIG. 7 exemplifies cross-sectional views of a substrate BP21 and a substrate BP22 having different thicknesses of substrates (layer thicknesses) as an example of the variations in the substrate characteristics. As illustrated in FIG. 7, between a line L211 and a line L212 of the substrate BP21 and a line L221 and a line L222 of the substrate BP22, the line widths are the same and patterns of prints are the same, while a layer thickness W21 and a layer thickness W22 are different. In a case where there are variations in the layer thicknesses in this way, EMI of the substrate BP21 and the substrate BP22 also changes because electrical characteristics also change between the substrate BP21 and the substrate BP22.

Note that, in FIGs. 6 and 7, the line width and the layer thickness are given as examples of the substrate characteristics, but similar problems arise with other substrate characteristics, such as the type of the substrate resin (dielectric constant), for example. For example, as an example of the type of the substrate resin, there are variations such as paper phenol substrates (FR-1 and FR-2), glass epoxy resin substrates (FR-4 and FR-5), and glass composite substrates (CEM-3). When these types of the substrate resin are different, EMI also changes because the dielectric constants are also different.

In this way, in order to train the EMI prediction model with circuit features with various substrate characteristics, a huge number of variations of training data is needed. However, the division and the combination exemplified in Advanced Technology 1 and Advanced Technology 2 only support reduction in the variations in the training data related to the branching patterns of the lines and the physical property value patterns of the elements on the circuits. Therefore, it is difficult to apply Advanced Technology 1 and Advanced Technology 2 to reduce the variations in the training data related to the substrate characteristics.

Therefore, the training data generation function according to the present embodiment classifies a group of circuits having the same circuit shape based on characteristic impedances, and selects a part of a plurality of circuits classified into the same group and deleting the rest, to generate training data for machine learning of an EMI prediction model.

One of the points of view in the present embodiment is a point that a circuit having different substrate characteristics but having a common current distribution and EMI may be identified from a characteristic impedance of the circuit. In other words, a line width, a layer thickness, and a dielectric constant determine a characteristic impedance of a line, that is, a resistance value in an alternating current circuit. Such a characteristic impedance determines a current distribution flowing through the circuit. Moreover, the current distribution determines EMI radiated by the circuit. Therefore, even when the substrate characteristics are different, as long as the characteristic impedance of the circuit is the same, the current distribution and the EMI are the same.

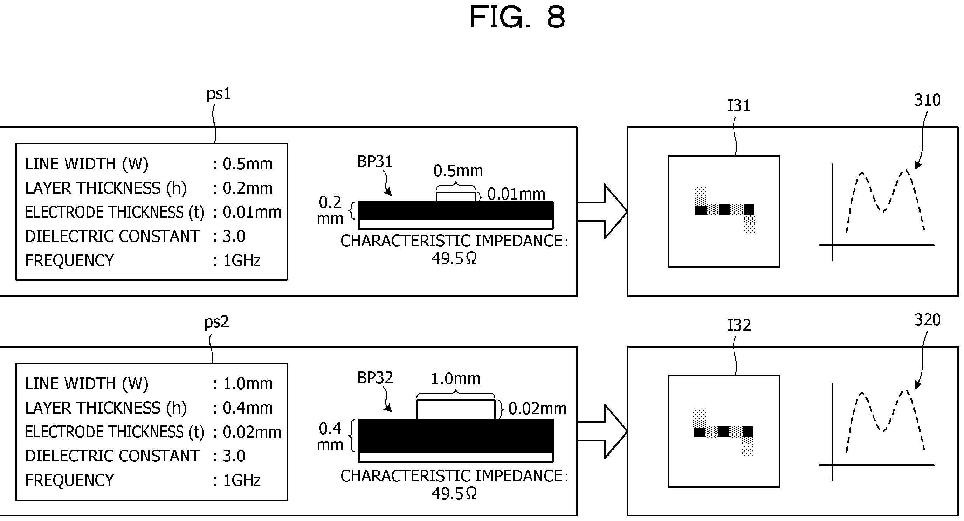

FIG. 8 is a diagram illustrating one aspect of a relationship between the characteristic impedance and the EMI. FIG. 8 exemplifies two substrate characteristic parameter sets ps1 and ps2 related to circuits having the same circuit shape. As illustrated in FIG. 8, the substrate characteristic parameter set ps1 includes four substrate characteristic parameters: a line width "0.5 mm", a layer thickness "0.2 mm", an electrode thickness "0.01 mm", a relative dielectric constant "3.0", and a frequency "1 GHz". The substrate characteristic parameter set ps1 may be schematically illustrated as in a substrate BP31 illustrated in FIG. 8. By inputting circuit information of such a substrate BP31 to the circuit simulator, a current distribution I31 and an EMI intensity 310 of the substrate BP31 may be calculated. Furthermore, the substrate characteristic parameter set ps2 includes four substrate characteristic parameters: a line width "1.0 mm", a layer thickness "0.4 mm", an electrode thickness "0.02 mm", a relative dielectric constant "3.0", and a frequency "1 GHz". The substrate characteristic parameter set ps2 may be schematically illustrated as in a substrate BP32 illustrated in FIG. 8. By inputting circuit information of such a substrate BP32 to the circuit simulator, a current distribution I32 and an EMI intensity 320 of the substrate BP32 may be calculated.

It is visually apparent that the substrate characteristic parameters are different between the substrate BP31 and the substrate BP32. On the other hand, both the substrate BP31 and the substrate BP32 have the same value of the characteristic impedance of 49.5 Ω. In a case where the characteristic impedances are the same value in this way, the current distribution I31 and the EMI intensity 310 and the current distribution I32 and the EMI intensity 320 are the same between the substrate BP31 and the substrate BP32. Thus, under a condition that an explanatory variable of an EMI prediction model is a current distribution, training data corresponding to each circuit of the substrate BP31 and the substrate BP32 may be considered to exist at the same position in a feature amount space. Therefore, it is apparent that deleting the training data corresponding to one of the substrate BP31 and the substrate BP32 does not adversely affect accuracy of EMI prediction of the EMI prediction model.

Accordingly, in the training data generation function according to the present embodiment, a part of circuits in a group having a common characteristic impedance is selected, and the rest is deleted. For example, when it is assumed that the number of circuits having a common characteristic impedance is M, by selecting at least one of the M circuits, a maximum of M - 1 circuits may be deleted. Note that, in the following, as merely an example, an example of selecting one of the M circuits having a common characteristic impedance and deleting the remaining M - 1 circuits will be described, but the number of circuits to be selected and the number of circuits to be deleted may be optionally set.

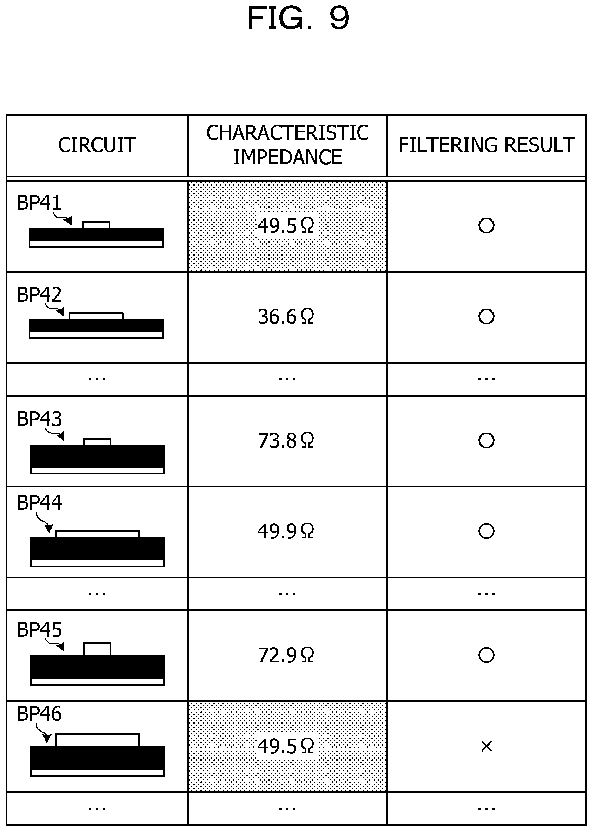

FIG. 9 is a diagram illustrating an example of filtering. FIG. 9 illustrates, in a table format, a correspondence relationship between schematic diagrams of circuits having the same circuit shape and enumerating different substrate characteristic parameters, characteristic impedances calculated from the respective circuits, and filtering results indicating whether or not pieces of training data corresponding to the respective circuits are excluded from a data set. In the example illustrated in FIG. 9, among six circuits of the substrates BP41 to BP46, characteristic impedances of two circuits of substrates BP41 and BP46 match. In this case, as merely an example, training data corresponding to the circuit of the substrate BP41 is selected as one of the set of the training data, and training data corresponding to the circuit of the substrate BP46 is deleted from the set of the training data. The characteristic impedances do not match in the circuits of the substrates BP42 to BP45 other than these substrates BP41 and BP46. Therefore, training data corresponding to the circuits of the substrates BP42 to BP45 is selected as one of the set of the training data.

As described above, the training data generation function according to the present embodiment selects a part of a plurality of circuits having the same circuit shape, different substrate characteristics, and similar characteristic impedances, to generate training data used for training an EMI prediction model using a current distribution as a feature amount. Therefore, the number of pieces of training data may be reduced because training data of a deleted circuit is not generated. Therefore, according to the training data generation function according to the present embodiment, it is possible to reduce variations in the training data related to substrate characteristics.

Next, a functional configuration of the server device 10 according to the present embodiment will be described. In FIG. 1, blocks corresponding to functions of the server device 10 are schematically illustrated. As illustrated in FIG. 1, the server device 10 includes a communication interface unit 11, a storage unit 13, and a control unit 15. Note that FIG. 1 merely illustrates an excerpt of functional units related to the data generation function described above, and a functional unit other than the illustrated ones, for example, a functional unit that an existing computer is equipped with by default or as an option may be provided in the server device 10.

The communication interface unit 11 corresponds to an example of a communication control unit that controls communication with another device, for example, the client terminal 30. As merely an example, the communication interface unit 11 may be implemented by a network interface card such as a LAN card. For example, the communication interface unit 11 receives, from the client terminal 30, a request for generating training data, or various user settings related to the training data generation function. Furthermore, the communication interface unit 11 outputs, to the client terminal 30, a set of training data generated by the training data generation function, a trained EMI prediction model, and the like.

The storage unit 13 is a functional unit that stores various types of data. As merely an example, the storage unit 13 is implemented by a storage, for example, an internal, external, or auxiliary storage. For example, the storage unit 13 stores a circuit information group 13A, a training data set 13B, and model data 13M. In addition to the circuit information group 13A, the training data set 13B, and the model data 13M, the storage unit 13 may store various types of data such as account information of users who receive provision of the training data generation function described above. Note that description of each piece of data of the circuit information group 13A, the training data set 13B, and the model data 13M will be described later together with description of processing in which reference or generation is performed.

The control unit 15 is a processing unit that performs overall control of the server device 10. For example, the control unit 15 is implemented by a hardware processor. As illustrated in FIG. 1, the control unit 15 includes a setting unit 15A, a calculation unit 15B, a classification unit 15C, a selection unit 15D, a generation unit 15E, and a training unit 15F.

The setting unit 15A is a processing unit that sets various parameters related to the training data generation function. As merely an example, the setting unit 15A may start operation in a case where a request for generating training data is received from the client terminal 30. At this time, the setting unit 15A sets a frequency f for which a characteristic impedance is to be calculated in a frequency domain from an aspect of evaluating a degree of similarity between circuits by classifying the circuits based on the characteristic impedances, for example, by clustering. In addition, the setting unit 15A sets a threshold Th to be compared with a distance d between clusters in the clustering of the circuits based on the characteristic impedances. For the frequency f and the threshold Th, user settings received via the client terminal 30 may be applied, or system settings determined by a designer or the like of the training data generation function described above may be applied.

The calculation unit 15B is a processing unit that calculates a characteristic impedance of a circuit. As merely an example, the calculation unit 15B refers to the circuit information group 13A stored in the storage unit 13. Here, the circuit information group 13A is a set of circuit information. Examples of such circuit information include circuit coupling information such as a netlist used in a circuit simulator such as a simulation program with integrated circuit emphasis (SPICE). For example, the circuit coupling information may be acquired by importing from a design support program such as a computer-aided design (CAD) system. For each circuit shape determined by such circuit information, the calculation unit 15B varies a numerical value within a range assigned to a substrate characteristic parameter for each substrate characteristic parameter. For example, the calculation unit 15B comprehensively sets numerical values within a range assigned as a variation for each substrate characteristic parameter, for example, numerical values used in a history of circuit design in the same domain. With this configuration, a plurality of training data candidate circuits having the same circuit shape and different substrate characteristics are enumerated.

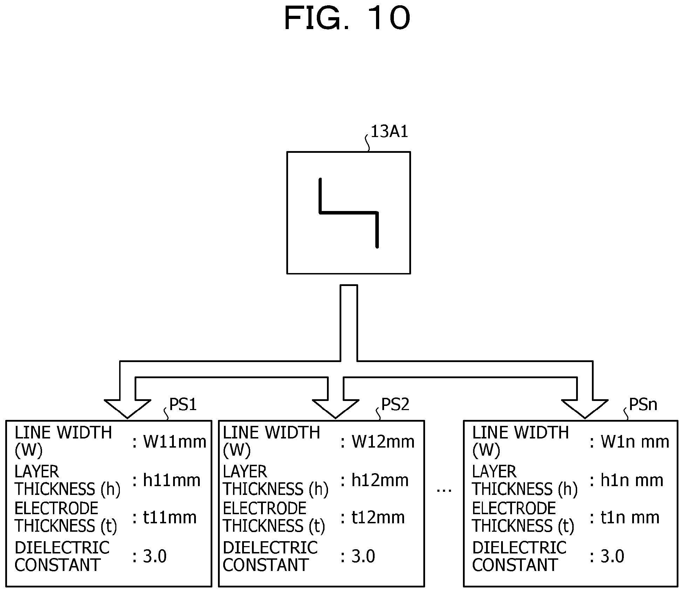

FIG. 10 is a diagram illustrating an example of an enumeration method of circuits. FIG. 10 illustrates an excerpt of an example in which circuit information 13A1 in the circuit information group 13A is used. As illustrated in FIG. 10, in a case where a circuit shape corresponding to the circuit information 13A1 is selected, n training data candidate circuits corresponding to substrate characteristic parameter sets PS1 to PSn are enumerated. For example, in the example of the substrate characteristic parameter set PS1, a training data candidate circuit having four substrate characteristic parameters: a line width "W11 (mm)", a layer thickness "h11 (mm)", an electrode thickness "t11 (mm)", and a relative dielectric constant "3.0 GHz" is defined. Furthermore, in the example of the substrate characteristic parameter set PS2, a training data candidate circuit having four substrate characteristic parameters: a line width "W12 (mm)", a layer thickness "h12 (mm)", an electrode thickness "t12 (mm)", and a relative dielectric constant "3.0 GHz" is defined. Moreover, in the example of the substrate characteristic parameter set PSn, a training data candidate circuit having four substrate characteristic parameters: a line width "W1n (mm)", a layer thickness "hin (mm)", an electrode thickness "tin (mm)", and a relative dielectric constant "3.0 GHz" is defined.

The calculation unit 15B sets a division line that divides a line of each training data candidate circuit by using, as a boundary, a point where the substrate characteristic parameters are discontinuous among the plurality of training data candidate circuits enumerated in this way. Then, the calculation unit 15B divides the line of each training data candidate circuit according to the previously set division line. With this configuration, a partial line obtained by dividing the line by the division line is obtained for each training data candidate circuit.

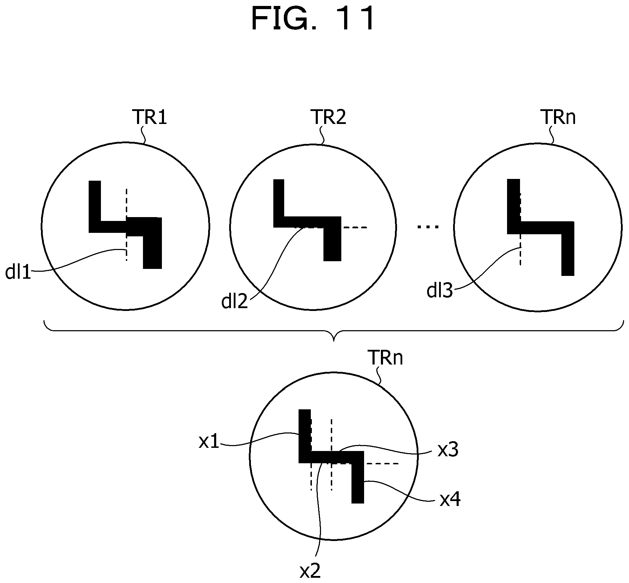

FIG. 11 is a diagram illustrating an example of a method of setting a division line for a line. FIG. 11 schematically illustrates n training data candidate circuits TR1 to TRn corresponding to the n substrate characteristic parameter sets PS1 to PSn illustrated in FIG. 10. Moreover, FIG. 11 gives an example of setting division lines by giving the line width as an example among the substrate characteristic parameters. For example, in the example of the training data candidate circuit TR1, a division line dl1 is set by using, as a boundary, a portion where the line width changes in the line of the training data candidate circuit TR1. Furthermore, in the example of the training data candidate circuit TR2, a division line dl2 is set by using, as a boundary, a portion where the line width changes in the line of the training data candidate circuit TR2. Moreover, in the example of the training data candidate circuit TRn, a division line dl3 is set by using, as a boundary, a portion where the line width changes in the line of the training data candidate circuit TRn. The lines of the training data candidate circuits TR1 to TRn are divided according to these division lines dl1 to dl3. With this configuration, the lines of the training data candidate circuits TR1 to TRn are divided into partial lines x1 to x4. Here, FIG. 11 illustrates an excerpt of the partial lines x1 to x4 of the training data candidate circuit TRn, but other training data candidate circuits are also divided into the same number of partial lines, that is, four partial lines x1 to x4.

Thereafter, the calculation unit 15B calculates the characteristic impedance for each training data candidate circuit according to the following Expression (1). In the following Expression (1), "w" refers to a line width, "h" refers to a layer thickness, and "t" refers to an electrode thickness. Furthermore, in the following Expression (1), "$\varepsilon r$" refers to a relative dielectric constant, which is a function of a frequency.

[Expression 1]

$$Z_0 = \frac{87.0}{(\varepsilon_r + 1.41)^{1/2}} In \left[ \frac{5.98h}{0.8w + t} \right]$$

... Expression (1)

For example, in the example illustrated in FIG. 11, substrate characteristic parameters such as the line width, the layer thickness, the electrode thickness, and the relative dielectric constant are input for each of the partial lines x1 to x4 of the training data candidate circuits TR1 to TRn. At this time, a frequency set by the setting unit 15A is used as the relative dielectric constant. With this configuration, the characteristic impedance is calculated for each of the partial lines x1 to x4. By vectorizing the characteristic impedances of these partial lines x1 to x4, a characteristic impedance vector Z0 indicated in the following Expression (2) is obtained. Note that the characteristic impedance vector Z0 given here is written in a normal font, but it may be written in bold or double lines to represent the vector.
[Expression 2]

$$Z_0 = (Z_0^{x1}, Z_0^{x2}, \cdots, Z_0^{xn})$$

... Expression (2)

The classification unit 15C is a processing unit that classifies training data candidate circuits based on characteristic impedances calculated by the calculation unit 15B. As merely an example, the classification unit 15C calculates a Euclidean distance between the characteristic impedance vectors Z0 for each pair of the training data candidate circuits. For example, in a case where the n training data candidate circuits TR1 to TRn are enumerated, the Euclidean distances corresponding to the number of combinations nC2 obtained by extracting two from the n training data candidate circuits TR1 to TRn are calculated. Then, the classification unit 15C executes clustering of the training data candidate circuits by using the nC2 Euclidean distances calculated for each pair of the training data candidate circuits. For example, in the case of using a group average method, which is one kind of hierarchical clustering, from an initial state in which all clusters are single training data candidate circuits, processing of recursively merging clusters where the distance d between the clusters is minimized is started. Then, the classification unit 15C repeats the processing of merging clusters where the distance d between the clusters is within the threshold Th set by the setting unit 15A. The training data candidate circuits obtained by such merging are identified as the same group.
The selection unit 15D is a processing unit that selects one or a plurality of training data candidate circuits from a plurality of training data candidate circuits classified into the same group by processing of classifying by the classification unit 15C. As merely an example, when it is assumed that the number of training data candidate circuits classified into the same group is M, by selecting at least one of the M circuits, the selection unit 15D may delete a maximum of M - 1 circuits. Note that, here, as merely an example, an example has been given in which one of the M training data candidate circuits classified into the same group is selected and the remaining M - 1 circuits are deleted, but the number of circuits to be selected and the number of circuits to be deleted may be optionally set. For example, it is also possible to select a maximum of M - 1 training data candidate circuits and delete at least one training data candidate circuit among the M training data candidate circuits.
The generation unit 15E is a processing unit that generates training data for machine learning based on one or a plurality of training data candidate circuits selected by the selection unit 15D. As merely an example, the generation unit 15E adds, to circuit coupling information, physical property values of elements, and the like of the training data candidate circuit selected by the selection unit 15D, a substrate characteristic parameter set of the training data candidate circuit. Thereafter, the generation unit 15E calculates a current distribution and an EMI intensity in the training data candidate circuit by inputting, to the circuit simulator, circuit information to which the substrate characteristic parameter set is added. For example, the generation unit 15E may calculate the current distribution and the EMI intensity by inputting the circuit information to the circuit simulator operating in the server device 10. Furthermore, the generation unit 15E may also make a request for calculating the current distribution and the EMI intensity by using an application programming interface (API) published by an external device, service, or software that executes the circuit simulator. Thereafter, the generation unit 15E generates training data in which the current distribution and the EMI intensity are associated.
More specifically, the circuit simulator calculates the current distribution for each frequency component included in a specific frequency domain. With this configuration, a current distribution image in which the current distribution of the circuit calculated by the circuit simulator, for example, an intensity of a current flowing on a substrate surface, is mapped in a two-dimensional map is obtained for each frequency component. Subsequently, the generation unit 15E identifies one or a plurality of resonant frequencies at which a maximum value of the current distribution calculated for each frequency component is maximized.
Thereafter, from an aspect of approximating a near field of an electronic circuit, the generation unit 15E executes process processing of processing pixel values of pixels included in the current distribution image corresponding to the resonant frequency described above based on a distance from a line of each pixel. For example, a current distribution image generated by moving a grayscale value closer to an upper limit value, for example, 255 corresponding to white, as a current flowing in a line increases, while moving the grayscale value closer to a lower limit value, for example, 0 corresponding to black, as the current decreases, is given as an example. In this case, as a distance from the line of a pixel included in the current distribution image decreases, a shift amount for shifting a grayscale value of the pixel to a side of the upper limit value is set larger. On the other hand, as the distance from the line of the pixel included in the current distribution image increases, the shift amount for shifting the grayscale value of the pixel to a side of the lower limit value is set smaller. By shifting the grayscale value of the pixel of the current distribution image according to such a shift amount, it is possible to obtain a current distribution image in which an intensity of the current is emphasized depending on the distance from the line. Note that, here, as merely an example, an example is given in which the distance from the line drawn as a 1-pixel line drawing is calculated for each pixel regardless of a size of the line width defined in the substrate characteristic parameter set, but the present invention is not limited to this. For example, a distance from a line drawn according to the line width defined in the substrate characteristic parameter set may be calculated for each pixel.

Then, the generation unit 15E generates training data in which the resonant frequency, the current distribution image, and the EMI intensity are associated. Here, the resonant frequency, which is a scalar value, is converted into a matrix that may be input to a standard neural network as an example of an EMI prediction model. For example, in a case where a plurality of pieces of input data of the resonant frequency and the current distribution image are input to an EMI prediction model, from an aspect of unifying a matrix of each channel into the same type, a matrix corresponding to a two-dimensional array of current distribution images is generated, and then a value of the resonant frequency is embedded in each element of the matrix. Training data is generated in which the matrix in which the resonant frequency is embedded generated in this way and the current distribution image (matrix) are associated with the EMI intensity, which is a correct answer label.

Thereafter, in a case where the training data is generated for each of all pieces of circuit information included in the circuit information group 13A, the generation unit 15E registers a set of training data generated for each piece of circuit information in the storage unit 13 as the training data set 13B.

The training unit 15F is a processing unit that trains an EMI prediction model by using training data for machine learning. As merely an example, in a case where training data is generated for each of all pieces of circuit information included in the circuit information group 13A, or in a case where the training data set 13B is saved in the storage unit 13, the training unit 15F executes the following processing. In other words, the training unit 15F trains an EMI prediction model by using a current distribution of training data included in the training data set 13B as a feature amount and an EMI intensity as an objective variable. For example, the generation unit 15E inputs, to the EMI prediction model, a resonant frequency corresponding to input data of a channel 1 and a current distribution image corresponding to input data of a channel 2. With this configuration, an EMI intensity estimated value is obtained as output of the EMI prediction model. Then, the training unit 15F updates parameters of the EMI prediction model based on a loss between the EMI intensity estimated value output from the EMI prediction model and the EMI intensity as a correct answer label. With this configuration, a trained EMI prediction model is obtained.

Data related to the trained EMI prediction model obtained in this way is saved in the storage unit 13 as the model data 13M. For example, in a case where a machine learning model is a neural network, the model data 13M may include parameters of the machine learning model such as a weight of each layer or a bias, including a layer structure of the machine learning model such as neurons and synapses of each layer including an input layer, a hidden layer, and an output layer.

In addition, the model provision service may be performed by providing model data of the trained EMI prediction model to the client terminal 30, or the EMI prediction service that predicts an EMI intensity of a circuit by using the trained EMI prediction model may be provided.

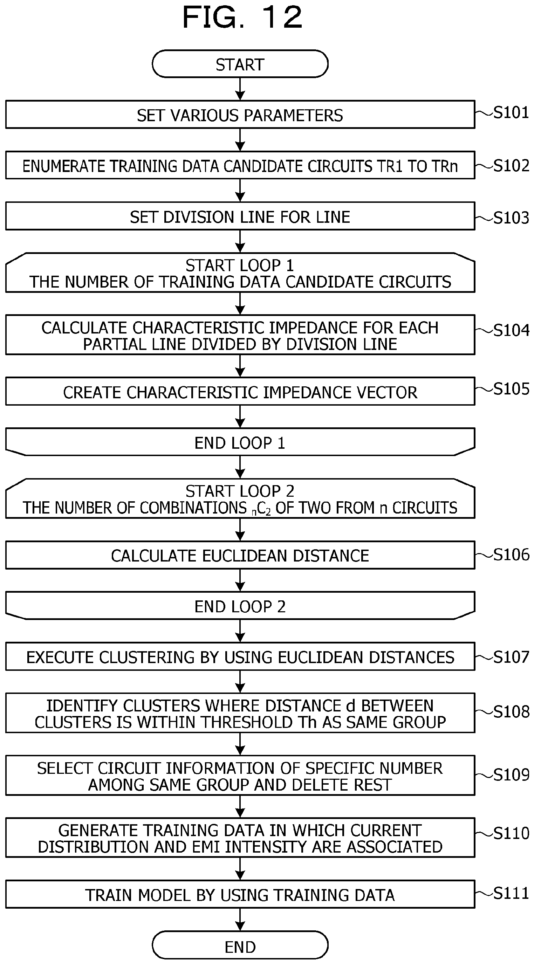

Next, a flow of processing of the server device 10 according to the present embodiment will be described. FIG. 12 is a flowchart illustrating a procedure of training data generation processing according to the first embodiment. As merely one aspect, this processing may be started in a case where a request for generating training data is received from the client terminal 30.

As illustrated in FIG. 12, the setting unit 15A sets various parameters such as the frequency f to be calculated for a characteristic impedance in a frequency domain and the threshold Th to be compared with the distance d between clusters in clustering of circuits based on the characteristic impedance (Step S101).

Subsequently, the calculation unit 15B enumerates the n training data candidate circuits TR1 to TRn by comprehensively setting, for each circuit shape determined by circuit information included in the circuit information group 13A, numerical values within a range assigned as variations in substrate characteristic parameters (Step S102).

Then, the calculation unit 15B sets a division line that divides a line of each training data candidate circuit by using, as a boundary, a point where the substrate characteristic parameters are discontinuous among the plurality of training data candidate circuits enumerated in Step S102 (Step S103).

Thereafter, the calculation unit 15B starts loop processing 1 for repeating processing in Steps S104 and S105, for the number of times corresponding to the number of the training data candidate circuits TR1 to TRn enumerated in Step S102. Note that, here, although an example in which the loop processing is performed is given, the processing of Steps S104 and S105 may be performed in parallel for each of the training data candidate circuits TR1 to TRn.

In other words, the calculation unit 15B calculates a characteristic impedance by substituting the substrate characteristic parameters into the Expression (1) described above for each partial line obtained by dividing a line of the training data candidate circuit by the division line set in Step S103 (Step S104).

Then, the calculation unit 15B vectorizes the characteristic impedance calculated for each partial line in Step S104 to create the characteristic impedance vector Z0 indicated in Expression (2) described above (Step S105).

By repeating such loop processing 1, the characteristic impedance vector Z0 may be obtained for each of the training data candidate circuits TR1 to TRn. Then, when the loop processing 1 ends, the classification unit 15C starts loop processing 2 for repeating processing in Step S106, for the number of times corresponding to the combinations nC2 obtained by extracting two from the n training data candidate circuits TR1 to TRn enumerated in Step S102.

In other words, the classification unit 15C calculates a Euclidean distance between the characteristic impedance vectors Z0 related to a pair of the two training data candidate circuits (Step S106). By repeating such loop processing 2 corresponding to Step S106, the Euclidean distance is obtained for each pair of the training data candidate circuits.

Thereafter, when the loop processing 2 ends, the classification unit 15C executes clustering of the training data candidate circuits by using the nC2 Euclidean distances calculated for the respective pairs of the training data candidate circuits in Step S106 (Step S107).

Then, the classification unit 15C identifies clusters where the distance d between the clusters obtained by the clustering in Step S107 is within the threshold Th set in Step S101 as the same group (Step S108).

Then, the selection unit 15D selects one training data candidate circuit among the training data candidate circuits classified into the same group, and deletes the remaining training data candidate circuits (Step S109).

Thereafter, the generation unit 15E generates training data for machine learning by associating a current distribution and an EMI intensity calculated by inputting circuit information of the training data candidate circuit selected in Step S109 to the circuit simulator (Step S110).

Then, the training unit 15F trains an EMI prediction model by using, in the training data generated in Step S110, the current distribution as a feature amount and the EMI intensity as an objective variable (S111). With this configuration, a trained EMI prediction model is obtained.

As described above, the training data generation function according to the present embodiment selects a part of a plurality of circuits having the same circuit shape, different substrate characteristics, and similar characteristic impedances, to generate training data used for training an EMI prediction model using a current distribution as a feature amount. Therefore, the number of pieces of training data may be reduced because training data of a deleted circuit is not generated. Therefore, according to the training data generation function according to the present embodiment, it is possible to reduce variations in the training data related to substrate characteristics.

[Second Embodiment]

Incidentally, while the embodiment related to the disclosed device has been described above, the present disclosure may be carried out in a variety of different modes apart from the embodiment described above. Therefore, in the following, another embodiment included in the present disclosure will be described.

In the first embodiment described above, an example has been given in which filtering based on clustering is performed on a plurality of training data candidate circuits having the same circuit shape and different substrate characteristics, but the filtering may also be performed according to another criterion other than the clustering.

In other words, a characteristic impedance of a line of an electronic circuit may be designed to take a specific value according to characteristics of a domain to which a task of an EMI prediction model is applied. Focusing on this point, a range to be assigned as a variation in substrate characteristic parameters is narrowed down to a range of a value of a characteristic impedance set based on a domain to be predicted. With this configuration, it is also possible to further reduce the number of pieces of training data.

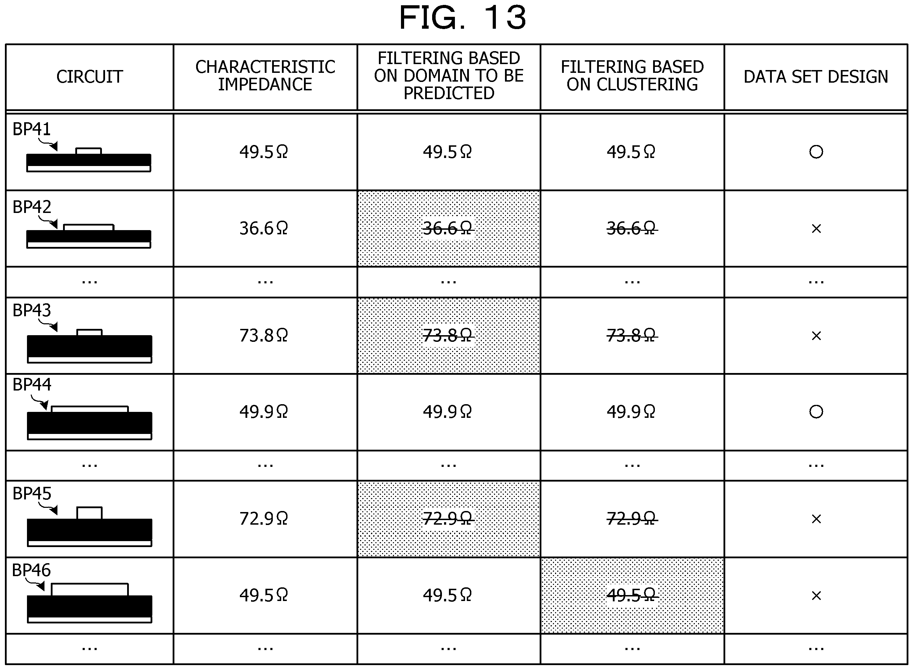

FIG. 13 is a diagram illustrating an application example of filtering. FIG. 13 illustrates, in a table format, a correspondence relationship between schematic diagrams of a plurality of training data candidate circuits, characteristic impedances, filtering results based on a domain to be predicted, filtering results based on clustering, and design results of a training data set. Moreover, FIG. 13 gives an example in which a value of the characteristic impedance corresponding to the domain to be predicted is set to 50 $\Omega$, and narrowing down to a range within $\pm 5$ $\Omega$ from 50 $\Omega$ is performed.

In the example illustrated in FIG. 13, among six training data candidate circuits of substrates BP41 to BP46, values of the characteristic impedances of three circuits of the substrates BP42, BP43, and BP45 are out of the range of 50 $\Omega \pm 5$ $\Omega$ set based on the domain to be predicted. In this case, the three training data candidate circuits of the substrates BP42, BP43, and BP45 are deleted. Moreover, the two circuits of the substrates BP41 and BP46 are clustered into the same group. In this case, as merely an example, the training data candidate circuit corresponding to the substrate BP41 is selected, and the training data candidate circuit corresponding to the substrate BP46 is deleted from the set of the training data. As a result, the training data candidate circuits corresponding to the substrates BP41 and BP44 are selected as one of the set of the training data.

In this way, by performing the filtering based on the domain to be predicted, it is also possible to further reduce the number of pieces of training data. In other words, in the example illustrated in FIG. 13, compared to the example illustrated in FIG. 9, the three circuits of the substrates BP42, BP43, and BP45 may be reduced from the training data set.

Furthermore, each of the illustrated components in each of the devices is not necessarily physically configured as illustrated in the drawings. In other words, specific modes of distribution and integration of the respective devices are not limited to those illustrated, and all or a part of the respective devices may be configured by being functionally or physically distributed and integrated in an optional unit depending on various loads, use situations, and the like. For example, the setting unit 15A, the calculation unit 15B, the classification unit 15C, the selection unit 15D, the generation unit 15E, or the training unit 15F may be coupled via a network as the external device of the server device 10. Furthermore, each of the setting unit 15A, the calculation unit 15B, the classification unit 15C, the selection unit 15D, the generation unit 15E, or the training unit 15F is included in another device, coupled to the network, and collaborates together so that the functions of the server device 10 described above may be implemented.

[Training Data Generation Program]

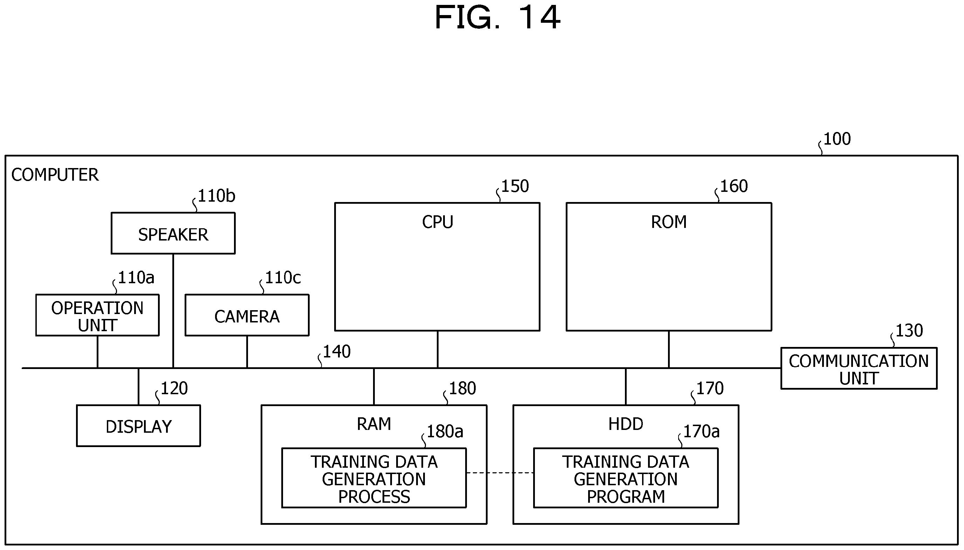

Furthermore, various types of processing described in the embodiments described above may be implemented by executing a program prepared in advance in a computer such as a personal computer or a workstation. Therefore, in the following, an example of a computer that executes a training data generation program having functions similar to those in the first and second embodiments will be described with reference to FIG. 14.

FIG. 14 is a diagram illustrating a hardware configuration example of the computer. As illustrated in FIG. 14, a computer 100 includes an operation unit 110a, a speaker 110b, a camera 110c, a display 120, and a communication unit 130. Moreover, the computer 100 includes a CPU 150, a ROM 160, an HDD 170, and a RAM 180. These respective units 110 to 180 are coupled via a bus 140.

Here, in FIG. 14, a CPU is given as an example of a hardware processor, but the present invention is not limited to this. In other words, not limited to general-purpose processors such as a CPU and an MPU, a deep learning unit (DLU), general-purpose computing on graphics processing units (GPGPU), a GPU cluster, or the like may be used.

As illustrated in FIG. 14, the HDD 170 stores a training data generation program 170a that exhibits functions similar to functions of the setting unit 15A, the calculation unit 15B, the classification unit 15C, the selection unit 15D, and the generation unit 15E indicated in the first embodiment described above. The training data generation program 170a may be integrated or separated similarly to each of the components of the setting unit 15A, the calculation unit 15B, the classification unit 15C, the selection unit 15D, and the generation unit 15E illustrated in FIG. 1. In other words, all pieces of data indicated in FIG. 1 do not necessarily have to be stored in the HDD 170, and it is sufficient that data for use in processing is stored in the HDD 170.

Under such an environment, the CPU 150 reads the training data generation program 170a from the HDD 170, and then loads the training data generation program 170a into the RAM 180. As a result, the training data generation program 170a functions as a training data generation process 180a as illustrated in FIG. 14. The training data generation process 180a loads various types of data read from the HDD 170 into a region assigned to the training data generation process 180a in a storage region included in the RAM 180, and executes various types of processing by using the various types of loaded data. For example, as an example of the processing executed by the training data generation process 180a, the processing illustrated in FIG. 12 or the like is included. Note that all the processing units indicated in the first embodiment described above do not necessarily have to operate in the CPU 150, and it is sufficient that a processing unit corresponding to processing to be executed is virtually implemented.

Note that the training data generation program 170a described above does not necessarily have to be stored in the HDD 170 or the ROM 160 from the beginning. For example, each program is stored in a "portable physical medium" such as a flexible disk, which is a so-called FD, a CD-ROM, a DVD disc, a magneto-optical disk, or an IC card to be inserted into the computer 100. Then, the computer 100 may acquire each program from these portable physical media to execute each acquired program. Furthermore, each program may be stored in another computer, server device, or the like coupled to the computer 100 via a public line, the Internet, a LAN, a WAN, or the like, and the computer 100 may acquire each program from these to execute each program.

CITATION LIST

PATENT DOCUMENT

Patent Document 1: Japanese Laid-open Patent Publication No. 2018-194919
Patent Document 2: Japanese Laid-open Patent Publication No. 2011-158373

REFERENCE SIGNS LIST

| 10 | Server device |
| 11 | Communication interface unit |
| 13 | Storage unit |
| 13A | Circuit information group |
| 13B | Training data set |
| 13M | Model data |
| 15 | Control unit |
| 15A | Setting unit |
| 15B | Calculation unit |
| 15C | Classification unit |
| 15D | Selection unit |
| 15E | Generation unit |
| 15F | Training unit |
| 30 | Client terminal |

**Claims**

1. A training data generation program for causing a computer to execute processing comprising:

   calculating a characteristic impedance of a circuit included in each of a first plurality of pieces of circuit information;
   classifying the plurality of pieces of circuit information based on the calculated characteristic impedance;
   selecting one or a plurality of pieces of circuit information from a second plurality of pieces of circuit information classified into a first group by the processing of classifying; and
   generating training data for machine learning based on the selected one or a plurality of pieces of circuit information.

2. The training data generation program according to claim 1, wherein
   the processing of generating includes processing of generating training data in which a space distribution of a current that flows through a circuit that corresponds to the selected one or a plurality of pieces of circuit information and a situation of electromagnetic wave radiation of the circuit are associated.

3. The training data generation program according to claim 2, for causing the computer to execute the processing further comprising
   training, by using a set of the training data, a machine learning model that uses the space distribution of the current as a feature amount and the situation of the electromagnetic wave radiation as an objective variable.

4. The training data generation program according to claim 1, wherein
   the first plurality of pieces of circuit information is generated by varying, for each substrate characteristic parameter related to the circuit, a numerical value within a range assigned to the substrate characteristic parameter.

5. The training data generation program according to claim 4, wherein

   the processing of calculating includes processing of calculating, for each circuit included in each of the first plurality of pieces of circuit information, a characteristic impedance of a partial line obtained by dividing a line of the circuit by using, as a boundary, a point where the substrate characteristic parameters are discontinuous among a plurality of circuits that corresponds to the first plurality of pieces of circuit information, and

the processing of classifying includes processing of clustering the plurality of pieces of circuit information based on a set of the characteristic impedances of the partial lines calculated for the respective circuits.

**6.** The training data generation program according to claim 5, wherein
the processing of classifying includes processing of calculating a distance between vectors between a pair of the circuits by using a vector that corresponds to the set of the characteristic impedances of the partial lines, and clustering the plurality of pieces of circuit information based on the distance.

**7.** The training data generation program according to claim 1, for causing the computer to execute the processing further comprising
processing of excluding, among the first plurality of pieces of circuit information, circuit information in which the characteristic impedance calculated in the processing of calculating is outside a range of a characteristic impedance that corresponds to a domain to which a task of a machine learning model that uses the training data is applied.

**8.** A training data generation method implemented by a computer, the method comprising:

calculating a characteristic impedance of a circuit included in each of a first plurality of pieces of circuit information;
classifying the plurality of pieces of circuit information based on the calculated characteristic impedance;
selecting one or a plurality of pieces of circuit information from a second plurality of pieces of circuit information classified into a first group by the processing of classifying; and
generating training data for machine learning based on the selected one or a plurality of pieces of circuit information.

**9.** The training data generation method according to claim 8, wherein
the processing of generating includes processing of generating training data in which a space distribution of a current that flows through a circuit that corresponds to the selected one or a plurality of pieces of circuit information and a situation of electromagnetic wave radiation of the circuit are associated.

**10.** The training data generation method according to claim 9, for causing the computer to execute the processing further comprising
training, by using a set of the training data, a machine learning model that uses the space distribution of the current as a feature amount and the situation of the electromagnetic wave radiation as an objective variable.

**11.** The training data generation method according to claim 8, wherein
the first plurality of pieces of circuit information is generated by varying, for each substrate characteristic parameter related to the circuit, a numerical value within a range assigned to the substrate characteristic parameter.

**12.** The training data generation method according to claim 11, wherein

the processing of calculating includes processing of calculating, for each circuit included in each of the first plurality of pieces of circuit information, a characteristic impedance of a partial line obtained by dividing a line of the circuit by using, as a boundary, a point where the substrate characteristic parameters are discontinuous among a plurality of circuits that corresponds to the first plurality of pieces of circuit information, and
the processing of classifying includes processing of clustering the plurality of pieces of circuit information based on a set of the characteristic impedances of the partial lines calculated for the respective circuits.

**13.** The training data generation method according to claim 12, wherein
the processing of classifying includes processing of calculating a distance between vectors between a pair of the circuits by using a vector that corresponds to the set of the characteristic impedances of the partial lines, and clustering the plurality of pieces of circuit information based on the distance.

**14.** The training data generation method according to claim 8, for causing the computer to execute the processing further comprising
processing of excluding, among the first plurality of pieces of circuit information, circuit information in which the characteristic impedance calculated in the processing of calculating is outside a range of a characteristic impedance that corresponds to a domain to which a task of a machine learning model that uses the training data is applied.

15. A training data generation apparatus comprising a control unit configured to perform processing including:

calculating a characteristic impedance of a circuit included in each of a first plurality of pieces of circuit information;
classifying the plurality of pieces of circuit information based on the calculated characteristic impedance;
selecting one or a plurality of pieces of circuit information from a second plurality of pieces of circuit information classified into a first group by the processing of classifying; and
generating training data for machine learning based on the selected one or a plurality of pieces of circuit information.

16. The training data generation apparatus according to claim 15, wherein
the processing of generating includes processing of generating training data in which a space distribution of a current that flows through a circuit that corresponds to the selected one or a plurality of pieces of circuit information and a situation of electromagnetic wave radiation of the circuit are associated.

17. The training data generation apparatus according to claim 16, for causing the computer to execute the processing further comprising
training, by using a set of the training data, a machine learning model that uses the space distribution of the current as a feature amount and the situation of the electromagnetic wave radiation as an objective variable.

18. The training data generation apparatus according to claim 15, wherein
the first plurality of pieces of circuit information is generated by varying, for each substrate characteristic parameter related to the circuit, a numerical value within a range assigned to the substrate characteristic parameter.

19. The training data generation apparatus according to claim 18, wherein

the processing of calculating includes processing of calculating, for each circuit included in each of the first plurality of pieces of circuit information, a characteristic impedance of a partial line obtained by dividing a line of the circuit by using, as a boundary, a point where the substrate characteristic parameters are discontinuous among a plurality of circuits that corresponds to the first plurality of pieces of circuit information, and
the processing of classifying includes processing of clustering the plurality of pieces of circuit information based on a set of the characteristic impedances of the partial lines calculated for the respective circuits.

20. The training data generation apparatus according to claim 19, wherein
the processing of classifying includes processing of calculating a distance between vectors between a pair of the circuits by using a vector that corresponds to the set of the characteristic impedances of the partial lines, and clustering the plurality of pieces of circuit information based on the distance.

# FIG. 1

# FIG. 2

# FIG. 3

# FIG. 4

FIG. 5

EP 4 227 847 A1

# FIG. 6

BP11

L11

BP12

L12

FIG. 7

BP21

L211    L212

W21

BP22

L221    L222

W22

# FIG. 8

EP 4 227 847 A1

# FIG. 9

| CIRCUIT | CHARACTERISTIC IMPEDANCE | FILTERING RESULT |
|---|---|---|
| BP41 | 49.5 Ω | ○ |
| BP42 | 36.6 Ω | ○ |
| ... | ... | ... |
| BP43 | 73.8 Ω | ○ |
| BP44 | 49.9 Ω | ○ |
| ... | ... | ... |
| BP45 | 72.9 Ω | ○ |
| BP46 | 49.5 Ω | × |
| ... | ... | ... |

# FIG. 10

13A1

| | |
|---|---|
| LINE WIDTH (W) | : W11mm |
| LAYER THICKNESS (h) | : h11mm |
| ELECTRODE THICKNESS (t) | : t11mm |
| DIELECTRIC CONSTANT | : 3.0 |

PS1

| | |
|---|---|
| LINE WIDTH (W) | : W12mm |
| LAYER THICKNESS (h) | : h12mm |
| ELECTRODE THICKNESS (t) | : t12mm |
| DIELECTRIC CONSTANT | : 3.0 |

PS2

...

| | |
|---|---|
| LINE WIDTH (W) | : W1n mm |
| LAYER THICKNESS (h) | : h1n mm |
| ELECTRODE THICKNESS (t) | : t1n mm |
| DIELECTRIC CONSTANT | : 3.0 |

PSn

FIG. 11

# FIG. 12

START

SET VARIOUS PARAMETERS ~S101

ENUMERATE TRAINING DATA CANDIDATE CIRCUITS TR1 TO TRn ~S102

SET DIVISION LINE FOR LINE ~S103

START LOOP 1
THE NUMBER OF TRAINING DATA CANDIDATE CIRCUITS

CALCULATE CHARACTERISTIC IMPEDANCE FOR EACH
PARTIAL LINE DIVIDED BY DIVISION LINE ~S104

CREATE CHARACTERISTIC IMPEDANCE VECTOR ~S105

END LOOP 1

START LOOP 2
THE NUMBER OF COMBINATIONS $_nC_2$ OF TWO FROM n CIRCUITS

CALCULATE EUCLIDEAN DISTANCE ~S106

END LOOP 2

EXECUTE CLUSTERING BY USING EUCLIDEAN DISTANCES ~S107

IDENTIFY CLUSTERS WHERE DISTANCE d BETWEEN
CLUSTERS IS WITHIN THRESHOLD Th AS SAME GROUP ~S108

SELECT CIRCUIT INFORMATION OF SPECIFIC NUMBER
AMONG SAME GROUP AND DELETE REST ~S109

GENERATE TRAINING DATA IN WHICH CURRENT
DISTRIBUTION AND EMI INTENSITY ARE ASSOCIATED ~S110

TRAIN MODEL BY USING TRAINING DATA ~S111

END

# FIG. 13

| CIRCUIT | CHARACTERISTIC IMPEDANCE | FILTERING BASED ON DOMAIN TO BE PREDICTED | FILTERING BASED ON CLUSTERING | DATA SET DESIGN |
|---|---|---|---|---|
| BP41 | 49.5Ω | 49.5Ω | 49.5Ω | ○ |
| BP42 | 36.6Ω | ~~36.6Ω~~ | ~~36.6Ω~~ | × |
| ... | ... | ... | ... | ... |
| BP43 | 73.8Ω | ~~73.8Ω~~ | ~~73.8Ω~~ | × |
| BP44 | 49.9Ω | 49.9Ω | 49.9Ω | ○ |
| ... | ... | ... | ... | ... |
| BP45 | 72.9Ω | ~~72.9Ω~~ | ~~72.9Ω~~ | × |
| BP46 | 49.5Ω | 49.5Ω | ~~49.5Ω~~ | × |
| ... | ... | ... | ... | ... |

EP 4 227 847 A1

# FIG. 14

EP 4 227 847 A1

<div align="center">

**INTERNATIONAL SEARCH REPORT**

</div>

| International application No. |
|---|
| PCT/JP2020/037829 |

| A. CLASSIFICATION OF SUBJECT MATTER |
|---|
| Int. Cl. G06F30/27(2020.01)i, G06F30/398(2020.01)i<br>FI: G06F17/50 666V, G06F17/50 604D |

According to International Patent Classification (IPC) or to both national classification and IPC

| B. FIELDS SEARCHED |
|---|
| Minimum documentation searched (classification system followed by classification symbols)<br>Int. Cl. G06F30/27, G06F30/398 |

Documentation searched other than minimum documentation to the extent that such documents are included in the fields searched

```
Published examined utility model applications of Japan       1922-1996
Published unexamined utility model applications of Japan     1971-2020
Registered utility model specifications of Japan             1996-2020
Published registered utility model applications of Japan     1994-2020
```

Electronic data base consulted during the international search (name of data base and, where practicable, search terms used)
IEEE Xplore; JSTPlus (JDreamIII)

| C. DOCUMENTS CONSIDERED TO BE RELEVANT | | |
|---|---|---|
| Category* | Citation of document, with indication, where appropriate, of the relevant passages | Relevant to claim No. |
| A | JP 2008-78392 A (SHARP CORP.) 03 April 2008 (2008-04-03), entire text, all drawings | 1-20 |
| A | JP 2019-101924 A (TOYOTA CENTRAL RESEARCH AND DEVELOPMENT LABORATORIES, INC.) 24 June 2019 (2019-06-24), entire text, all drawings | 1-20 |
| A | JP 2019-82874 A (HITACHI, LTD.) 30 May 2019 (2019-05-30), entire text, all drawings | 1-20 |
| A | JP 2011-158373 A (DAINIPPON SCREEN MFG. CO., LTD.) 18 August 2011 (2011-08-18), entire text, all drawings | 1-20 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 16.11.2020 | 01.12.2020 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

INTERNATIONAL SEARCH REPORT

Information on patent family members

International application No.

PCT/JP2020/037829

| Patent Documents referred to in the Report | Publication Date | Patent Family | Publication Date |
|---|---|---|---|
| JP 2008-78392 A | 03.04.2008 | (Family: none) | |
| JP 2019-101924 A | 24.06.2019 | (Family: none) | |
| JP 2019-82874 A | 30.05.2019 | (Family: none) | |
| JP 2011-158373 A | 18.08.2011 | (Family: none) | |

Form PCT/ISA/210 (patent family annex) (January 2015)

## REFERENCES CITED IN THE DESCRIPTION

**Patent documents cited in the description**

- JP 2018194919 A
- JP 2011158373 A